# EUROPEAN PATENT SPECIFICATION

(11) **EP 3 087 588 B1**
(45) Date of publication and mention of the grant of the patent: **20.03.2019**
(21) Application number: 13900562.3
(22) Date of filing: 27.12.2013
(51) Int. Cl.: H01L 21/3065, H01L 21/336, H01L 29/423, H01L 21/67, H01L 29/66, H01L 29/06

(54) **SELECTIVE ETCHING FOR GATE ALL AROUND ARCHITECTURES**
SELEKTIVE ÄTZUNG FÜR GATE-ARCHITEKTUREN
GRAVURE SÉLECTIVE POUR ARCHITECTURES À GRILLE ENROBANTE

(43) Date of publication of application: 02.11.2016
(73) Proprietor: Intel Corporation, Santa Clara, CA 95054 (US)
(72) Inventor: SUNG, Seung Hoon, Beaverton, OR 97006 (US); TURKOT, Robert B. Jr., Santa Clara, CA 95054 (US); MURTHY, Anand, Portland, OR 97229 (US); KIM, Seiyon, Portland, OR 97229 (US); KUHN, Kelin, Aloha, OR 97006 (US)
(74) Representative: Goddar, Heinz J.
(86) International application number: PCT/US2013/077957
(87) International publication number: WO 2015/099761

(56) References cited:
- WO-A1-2013/095652
- JP-A- 2008 523 591
- US-A1- 2005 045 276
- US-A1- 2005 045 276
- US-A1- 2005 170 659
- US-A1- 2010 295 022
- US-A1- 2012 007 052
- US-A1- 2013 153 997
- US-A1- 2013 153 997
- US-A1- 2013 161 756
- US-B2- 7 101 761

## Description

### FIELD

The present disclosure relates to selective etching for gate all around architectures using vapor phase etching techniques with interhalogen or halogen - noble element compounds.

### BACKGROUND

As semiconductor devices shrink, the use of three dimensional topology increases. Gate all around architectures, including nano wires to form a portion of the channels, are being implemented in transistor design. Using replacement metal gate methods in forming such designs, sacrificial materials are used in various steps to provide scaffolds for forming other features in the device. For example, a sacrificial gate material is deposited and sidewall spacers are formed on both sides of the sacrificial gate. Later in the process, the sacrificial material is then removed to make way for the actual gate electrode to be deployed in the transistor. Similarly, sacrificial layers are formed between the nanowires to support the nanowires during fabrication.

However, the sacrificial layer material between the nanowires, for example, tends to be not much different in composition from the nanowire material. Wet etch out of the sacrificial material has potential challenges such as channel collapse, etch selectivity problems, and the inability of the etchant to reach all of the surfaces to be etched. Isotropic etch out using plasma etch is believed to improve the accessibility of the etchant to surfaces to be etched, however, damage from the plasma and etch selectivity remain to be improved. Thus, room remains for improvement in providing an etching process wherein etch selectivity is relatively high, improvement in the accessibility of the etching material into feature geometry, and material damage is minimized in forming three dimensional topologies using replacement gate methods.

US2012007052 A1 discloses an apparatus, system, and method for dual-channel FET devices. The nanowire FET device may include a first transistor on a substrate, where the first transistor includes a first group of nanowires made of silicon. The nanowire FET device may also include a second transistor on the same substrate, where the second transistor includes a second group of nanowires made of silicon-germanium.

US2013161756 A1 discloses techniques for customization of nanowire transistor devices. Sacrificial fins are removed and replaced with custom material stacks of arbitrary composition and strain suitable for a given application. In one case, each of a first set of the sacrificial fins is recessed or otherwise removed and replaced with a p-type layer stack, and each of a second set of the sacrificial fins is recessed or otherwise removed and replaced with an n-type layer stack.

US2013153997 A1 discloses a method of forming a hybrid semiconductor structure on an SOI substrate. The method includes an integrated process flow to form a nanowire mesh device and a bulk CMOS device on the same SOI substrate.

US2010295022 A1 discloses nanowire-based field-effect transistors (FETs) and techniques for the fabrication thereof are provided. A FET is provided having a plurality of device layers oriented vertically in a stack, each device layer having a source region, a drain region and a plurality of nanowire channels connecting the source region and the drain region, wherein one or more of the device layers are configured to have a different threshold voltage from one or more other of the device layers; and a gate common to each of the device layers surrounding the nanowire channels.

US2005045276 A1 discloses an etching method comprising, providing a substrate; providing a sacrificial layer directly or indirectly on the substrate; providing one or more micromechanical structural layers on the sacrificial layer; performing a first etch to remove a portion of the sacrificial layer, the first etch comprising providing an etchant gas and energizing the etchant gas so as to allow the etchant gas to physically, or chemically and physically, remove the portion of the sacrificial layer; performing a second etch to remove additional sacrificial material in the sacrificial layer, the second etch comprising providing a gas that chemically but not physically etches the additional sacrificial material.

### BRIEF DESCRIPTION OF THE DRAWINGS

The above-mentioned and other features of this disclosure, and the manner of attaining them, may become more apparent and better understood by reference to the following description of embodiments described herein taken in conjunction with the accompanying drawings, wherein:
FIG. 1 illustrates a flow chart of a of etching sacrificial material from between channel layers in a semiconductor device;
FIG. 2a and FIG. 2b illustrate a flow chart of an embodiment of a method of forming a gate all around device. The flow chart begins on FIG. 2a and ends on FIG. 2b;
FIG. 3a illustrates an embodiment of a fin formed on a semiconductor substrate including a stack of alternating layers of channel material and sacrificial material capped with a hard mask, shallow trench isolation regions are also illustrated;
FIG. 3b illustrates an embodiment of the fin stack with a sacrificial gate electrode formed over the fin stack;
FIG. 3c illustrates an embodiment of side wall spacers formed on both sides of the sacrificial electrode over the fin stack;
FIG. 3d illustrates a cross-sectional view of FIG. 3c taken through line 3d-3d;
FIG. 3e illustrates the semiconductor device wherein the fin stack has been removed to make way for source and drain material growth;
FIG. 3f illustrates a cross-section of the semiconductor device including a source and drain grown on both sides of the side wall spacers;
FIG. 3g illustrates a perspective view of an embodiment of a semiconductor device including an interlayer dielectric deposited over the source and drain regions; and
FIG. 3h illustrates a cross-section of an embodiment of a semiconductor device wherein the sacrificial gate has been removed;
FIG. 3i illustrates a cross-sectional view of 3h taken through line 3i-3i;
FIG. 3j illustrates an embodiment of the semiconductor device wherein the hardmask and sacrificial material layers are removed;
FIG. 3k illustrates an embodiment of the semiconductor device wherein a dielectric layer is formed over the channel material and the gate electrode is formed around the channel material.

### DESCRIPTION

As noted above, as scaling of transistors continues, the need for three-dimensional topology becomes relatively indispensable. Gate all around architectures, including nanowires, have been implemented in metal-oxide-semiconductor or complimentary metal-oxide-semiconductor transistor design along with tri-gate (or fin field effect transistor) architecture. In using replacement metal gate or subtractive metal gate processes to form the three dimensional transistors, sacrificial materials are utilized during various steps and are then removed during the formation of transistors. For example, sacrificial layers are used between nanowire layers to make way for a gate electrode that is formed later in the flow process. The sacrificial material, however, tends to be compositionally similar to the channel material that forms the nanowires. Wet etch out of the sacrificial material has potential challenges such as channel collapse, etch selectivity, and the ability of the etchant to reach all of the surfaces to be etched. Isotropic etch out using plasma etch is believed to improve the accessibility of the etchant to surfaces to be etched, however damage from the plasma occurs and etch selectivity remains to be improved.

In the processes described herein interhalogen and halogen - noble element compounds are used in the vapor phase to etch sacrificial material from around channel material to form nanowires that provides at least a portion of the channels in the transistor. The etching process does not require a mask when removing the sacrificial layers between the nanowires as the etchant exhibits selectivity to other materials such as the interlayer dielectric, shallow trench materials, gate spacers, and source and drain materials. Furthermore, the process allows for improved accessibility of the etchant into the features of the device.

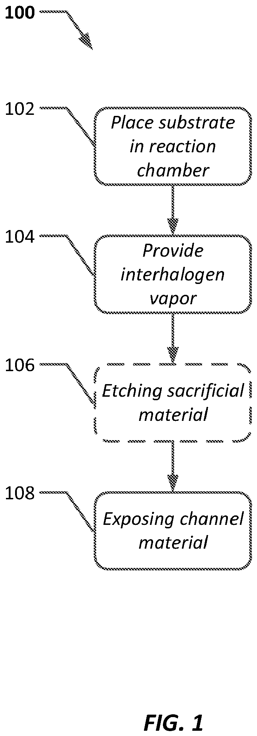

In embodiments, the present disclosure is directed to a method of etching sacrificial material used in forming semiconductor devices. As illustrated in the embodiment of FIG. 1, the process 100 generally includes supplying a semiconductor substrate in a reaction chamber 102. The semiconductor substrate includes, for example, a channel material, which may be disposed on the substrate or formed from a portion of the semiconductor substrate. A channel is understood herein as a region of material in a semiconductor between a source and drain, which flows either electrons or holes depending on the type of field effect transistor, i.e., NMOS or PMOS. Further, the semiconductor substrate also includes a sacrificial material disposed on at least a portion of the channel material, including over the channel material, under the channel material, or surrounding the channel material on more than one side. The sacrificial material is understood to be a material that is initially deposited to provide a temporary scaffold, supporting the formation of gate-all-around structures of the transistor and is then removed. In the case of forming nanowires, the channel layers are supported by the sacrificial layers during a significant portion of fabrication. For example, in the case of a gate all around device employing nanowires to form the channels, the sacrificial layers in the channel region between the nanowires are replaced with a gate dielectric and gate electrode.

In embodiments, the semiconductor substrate is formed from a single crystal material such as silicon, germanium, silicon germanium or a Group III-V compound semiconductor material. In other embodiments, the substrate is formed from a silicon-on-insulator substrate wherein an upper insulator layer composed of a material that includes, but is not limited to, silicon dioxide, silicon nitride or silicon oxy-nitride, disposed on a single crystal material. The channel material may be selected from one or more of the following materials silicon (Si), germanium (Ge), silicon germanium (SiGe), gallium arsenic (GaAs), indium tin (InSb), gallium phosphorus (GaP), gallium antimony (GaSb), indium aluminum arsenic (InAlAs), indium gallium arsenic (InGaAs), gallium antimony phosphorous (GaSbP), gallium arsenic antimony (GaAsSb), indium phosphorus (InP), and graphene. The sacrificial material comprises a semiconductor comprising group III, group IV or group V elements, wherein in embodiments, the group III, group IV, or group V elements are selected from the group consisting of carbon, nitrogen, gallium, silicon, germanium, tin and combinations thereof. In one embodiment, the channel material and the sacrificial material both include silicon. In preferred embodiments the channel material includes silicon and the sacrificial material includes silicon germanium.

Then an interhalogen or halogen-noble element vapor is provided in the reaction chamber 104 proximate to the sacrificial material. An interhalogen is understood as a compound that includes at least two different halogen atoms. Interhalogens for use herein include, for example, combinations of chlorine, fluorine, bromine, and iodine. The compositions may be diatomic, triatomic, or tetratomic, and include compounds such as iodine monochloride (ICl), iodine monobromide (IBr), chlorine trifluoride (ClF₃), bromine trifluoride (BrF₃) and iodine tetrachloride (ICl₄). A halogen-noble element vapor include both a halogen atom and a noble element atom, including materials such as xenon difluoride (XeF₂), xenon tetrafluoride (XeF₄), xenon hexafluoride (XeF₆), or xenon dibromide (XeBr₂).

In embodiments, the interhalogen or halogen-noble element is available as a vapor at a temperature in the range of -100 °C to 600 °C, including all values and ranges therein and, preferably at a temperature in the range of 20 °C to 30 °C, including all values and ranges therein. Furthermore, the interhalogen compound or halogen-noble element compound may have an etch selectivity of the sacrificial material to the channel layer in the range of 100:1 to 1000:1, including all ratios therein. The interhalogen or halogen-noble element compound may be supplied to the reaction chamber at a flow rate in the range of 1 sccm to 1000 sccm, including all values and ranges therein, and preferably in the range of 10 sccm to 200 sccm.

A carrier gas may be supplied with the interhalogen or halogen-noble element compounds, including Ar, He, or N₂, and preferably Ar. The ratio of the carrier gas to the etchant gas, by volume, is in the range of 100:1 to 1:100, including all values and ranges therein, and preferably from 10:1 to 1:10. The flow rate of the carrier gas may be in the range of 1 sccm to 1,000 sccm, including all values and ranges therein, and preferably in the range of 10 sccm to 200 sccm.

During processing, the pressure in the reaction chamber may be maintained in the range of 1 millitorr to 100 millitorr, including all values and ranges therein, such as 10 millitorr. Pressure in the reaction chamber may be maintained, in part, using a single or dual stage vacuum pump system coupled to the reaction chamber as well as by the flow of gas entering the reaction chamber.

At least a portion of the sacrificial material is then etched with the vapor 106. The semiconductor substrate may be heated at a temperature in the range of -100 °C to 600 °C during etching and, preferably heated at a temperature in the range of 20 °C to 30 °C. Etching of the sacrificial layer may occur for a time period in the range of 1 second to 600 seconds, including all values and ranges therein. At least a portion of the channel material under the sacrificial material is then exposed 108.

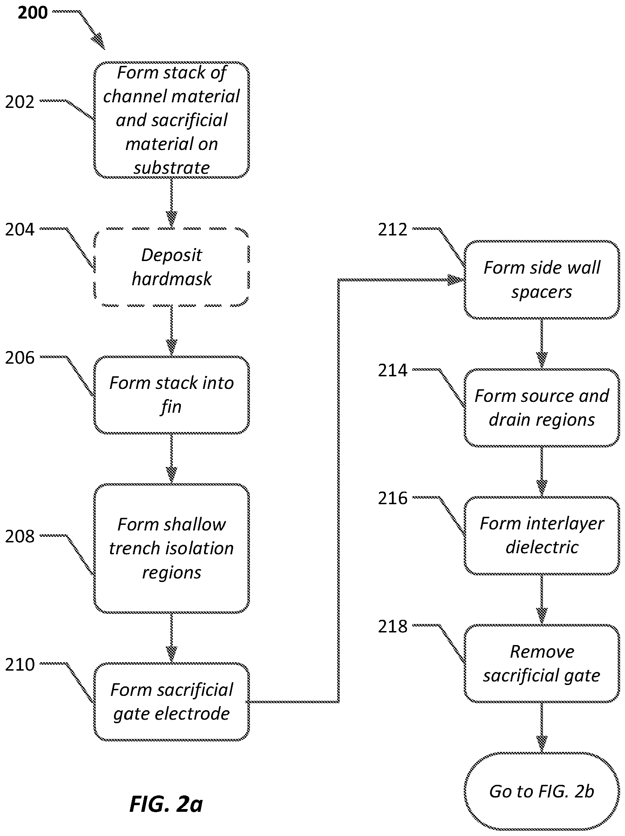

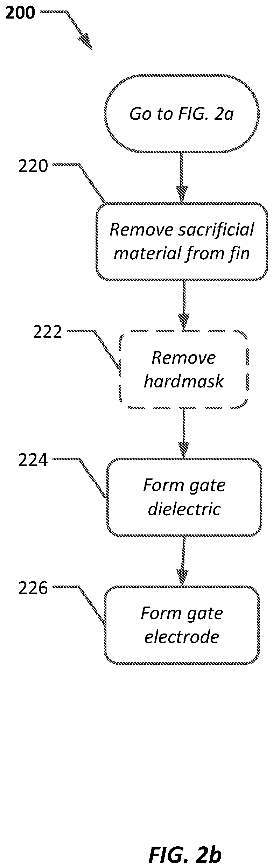

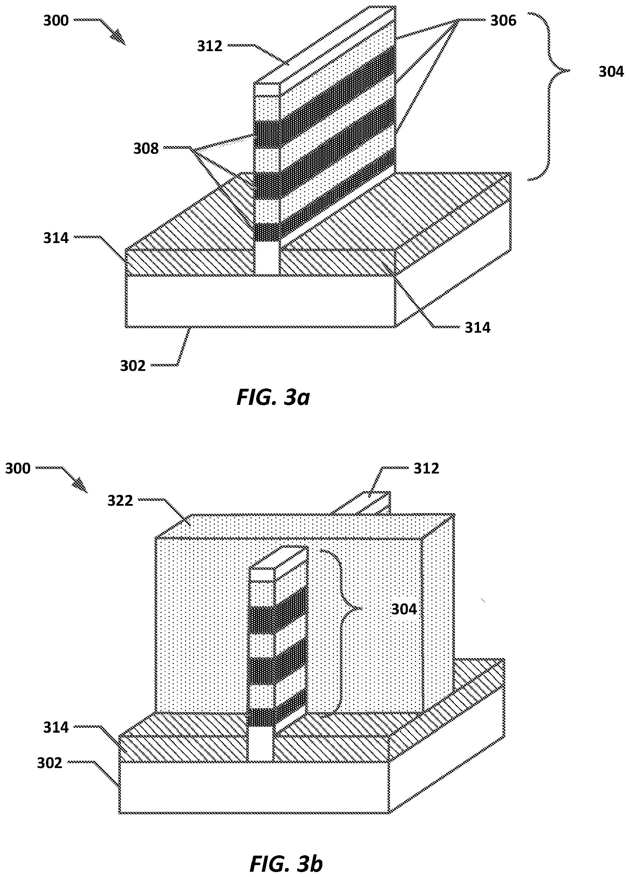

In an embodiment of the above, the sacrificial material is deposited as a layer on the semiconductor substrate and the channel material is deposited as a layer on the sacrificial material, such that the sacrificial material spaces the channel layer from the substrate as is the case in an embodiment of the gate all around devices. In particular embodiments, alternating layers of the sacrificial material and channel material are formed in a stack as will be described further herein with reference to FIG. 2 and FIGS. 3a through 3h. Removal of the sacrificial layers from between the channel layers forms nanowires. The nanowires exhibit, not only square cross-sections as illustrated, but may also exhibit round, rectangular (nanoribbons), hexagonal, octagonal, or triangular cross-sections. Reference to nanowire herein includes the various geometries described above.

FIG. 2 illustrates a flow chart of an embodiment of forming a semiconductor device including gate all around architecture. In this embodiment, the gates include a plurality of nanowires spaced from the surface of the semiconductor substrate. FIGS. 3a through 3h illustrate the changes in the semiconductor at various points through the formation process. It is noted that reference numbers beginning with the number "2" refer to FIG. 2 and reference numbers beginning with the number "3" refer to FIGS. 3a through 3h.

The method 200 begins with forming a stack of alternating layers of the sacrificial material and channel material on a semiconductor substrate 202. In a particular embodiment, the sacrificial material layers are formed from silicon germanium layers and the channel material layers are formed from silicon. In embodiments, the layers are formed via chemical vapor deposition, atomic layer deposition, molecular beam epitaxy, metal organic chemical vapor deposition, plasma enhanced chemical vapor deposition, physical vapor deposition, or plasma enhanced physical vapor deposition, depending on the content of the layer. The layers are formed in an alternating manner beginning with forming a sacrificial layer on the substrate. From 2 to 20 alternating layers may be formed, including all values and ranges therein, although three sacrificial layers and three channel material layers are shown.

An optional hardmask is then deposited over the stack of alternating sacrificial layers and channel material layers 204. The hardmask material may include, for example, silicon, porous silicon, amorphous silicon, silicon nitride, silicon oxynitride, silicon oxide, silicon dioxide, silicon carbonitride, silicon carbide, aluminum oxide, hafnium oxide, zirconium oxide, tantalum silicate, lanthanum oxide, polymer materials, etc. Again, the hardmask material may be formed from chemical vapor deposition, atomic layer deposition, plasma enhanced chemical vapor deposition, physical vapor deposition, or plasma enhanced physical vapor deposition, again depending on the layer composition and desired properties.

The stack of alternating layers of the sacrificial material and channel material and the optional hardmask are then patterned and etched to form the stack into a fin extending from the surface of the substrate 206. FIG. 3a illustrates a fin stack 304 of alternating sacrificial layers 306 and channel material layers 308 formed over a substrate 302. In the illustrated example, the optional hardmask 312 is illustrated as deposited on top of the stack 304. The sacrificial layers may have a thickness in the range of 1 to 100 nm, including all values and ranges therein. The channel material may have a thickness in the range of 1 nm to 100 nm, including all values and ranges therein. Furthermore, the hardmask may have a thickness in the range of 1 to 100 nm, including all values and ranges therein. The width of the fin stack may be in the range of 1 nm to 150 nm, including all values and ranges therein

Referring again to FIG. 2, the shallow trench isolation regions are formed on both sides of the fin 208. In embodiments, trench regions may be etched into the substrate surface and a dielectric such as silicon oxide, silicon nitride, silicon oxynitride and combinations thereof, may be deposited into the trench to form the isolation regions. The shallow trench isolation regions may also be formed using chemical vapor deposition, spin on, or physical vapor deposition techniques. The shallow trench isolation regions are illustrated as item 314 in FIG. 3a. The shallow trench isolation regions may have a thickness in the range of 1 to 200 nm, including all values and ranges therein.

Referring again to FIG. 2, a sacrificial gate is then formed over the top and side walls of the stack 210 using patterning and chemical vapor deposition techniques. Examples of a sacrificial gate include polycrystalline silicon. FIG. 3b illustrates the sacrificial gate 322 formed around the fin 304.

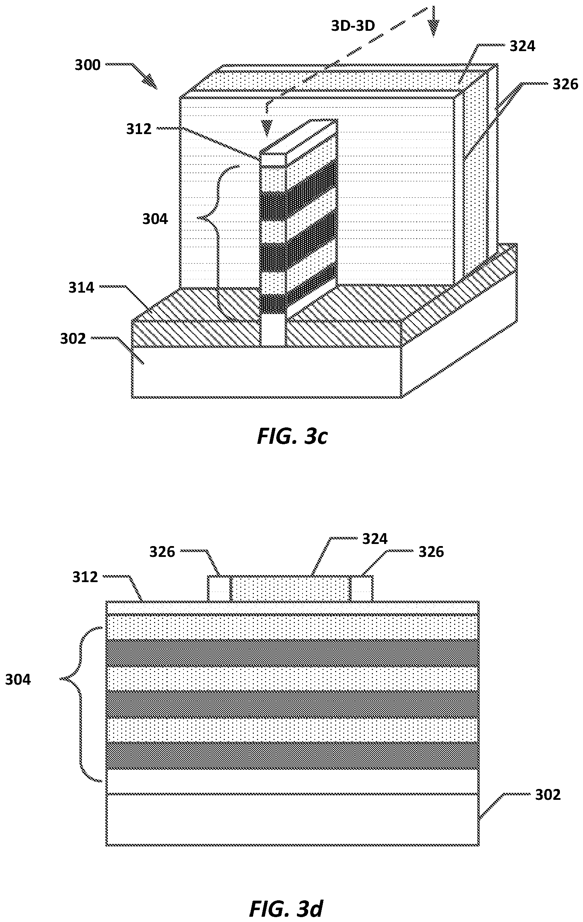

Again referring to FIG. 2, sidewall spacers are then formed on both sides of the sacrificial gate electrode 212 from silicon oxide, silicon nitride, silicon oxynitride or combinations thereof via chemical vapor deposition or atomic layer deposition, wherein anisotropic etching is used to remove excess spacer material. The sidewall spacers may exhibit a thickness in the range of 10 Å to 100 Å in width. FIGS. 3c and 3d illustrate the sacrificial gate material 324 and sidewall spacers 326 formed on both sides of the sacrificial gate 324 and around each side of the fin 304, i.e., around the side walls and top surface). As illustrated, the electrode is formed over all sides of the fin 304 (again, around the side walls and top surface).

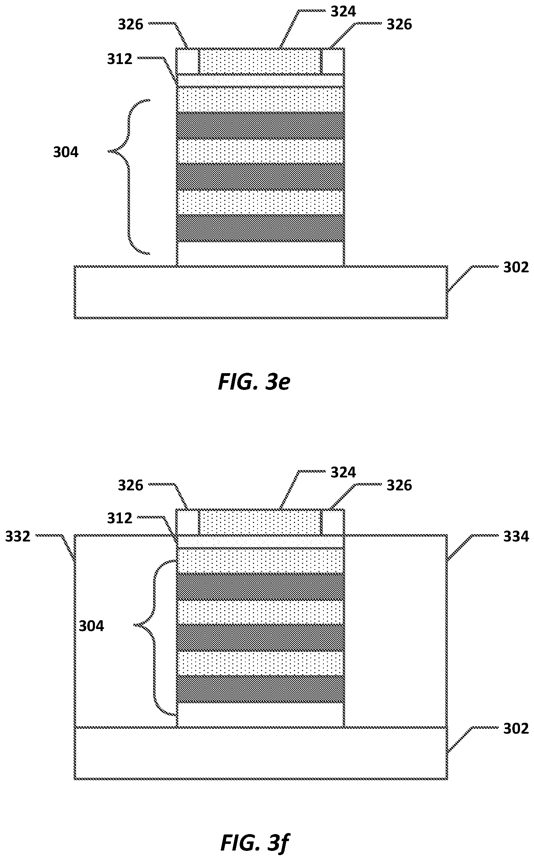

The source and drain regions of the nanowires may then be formed (as seen in FIG. 2, 214). The channel material and sacrificial material layers on either side of the side wall spacers are removed to make way for growth of the source and drain regions. The source and drain regions may be formed by, for example, epitaxial growth of silicon, doped silicon, germanium, silicon germanium, or other IIIV elements depending on the channel material and coupled to the portions of the fin stack between the spacers. In NMOS devices, source structures, drain structures, or both, may be n-doped silicon. In PMOS devices, source structures, drain structures, or both, may be p-doped silicon. Doping of the structures may be introduced during the growth process, by plasma doping, by solid source doping, etc. In other embodiments, the exposed portions of the gate stack 304 on either side of the sacrificial gate (only one is illustrated) may provide a source region and a drain region by doping the channel material. FIG. 3e illustrates the fin stack 304 after the removal of the source and drain regions of the fin 204 and FIG. 3f illustrate the fin stack 304 after the formation of the source region 332 and drain region 334.

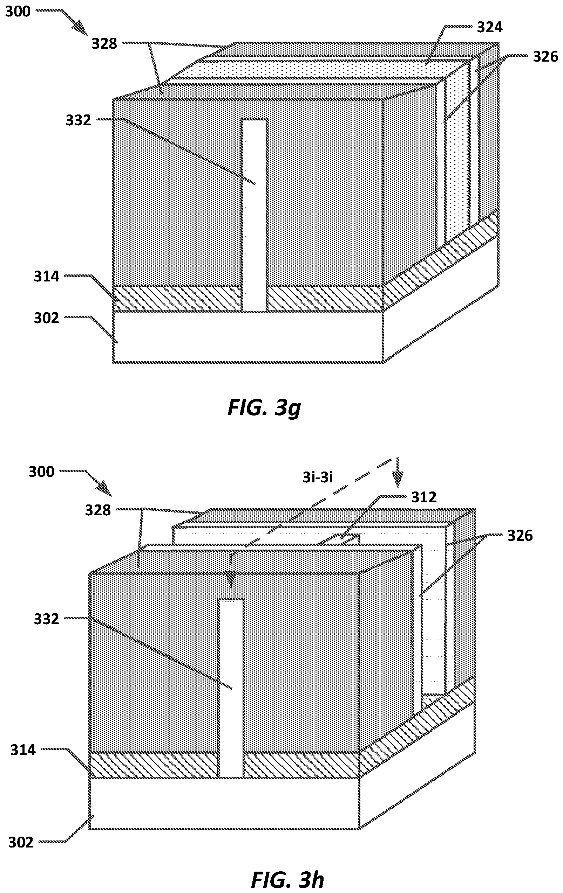

An interlayer dielectric is then deposited over the shallow trench isolation regions and the source and drain regions 216. The interlayer dielectric may be deposited using chemical vapor deposition and may include materials such as undoped silicon oxide, doped silicon oxide (e.g., BPSG, PSG), silicon nitride and silicon oxynitride. The interlayer dielectric is polished to expose the fin stack 304. The interlayer dielectric 328 is illustrated in FIG. 3g situated on either side of the side wall spacers 326, covering the source and drain regions 332 (334 is not illustrated) and the shallow trench isolation regions 314 .

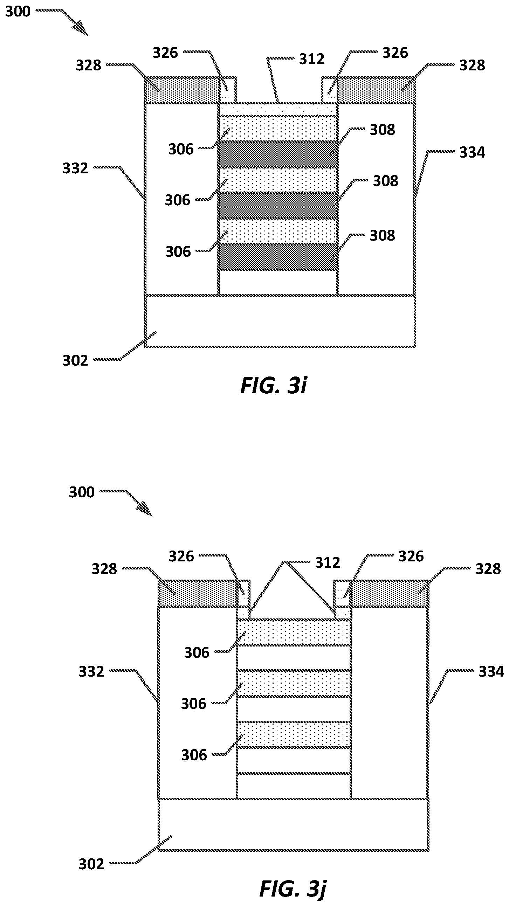

The sacrificial gate electrode is then removed 218 from the fin stack. The sacrificial gate electrode may be removed by etching with an appropriate etchant. FIG. 3h illustrates the device with the sacrificial gate electrode removed and FIG. 3i illustrates a cross-section of FIG. 3h through line 3i-3i. The sacrificial layers are removed from between the channel layer 220 in the fin using the interhalogen or halogen-noble element vapor as discussed above, forming nanowires in the channel region. Again, a mask to protect the remaining exposed material need not be provided. Then the optional hardmask is removed 222. FIG. 3j illustrates the semiconductor device 300 with the sacrificial layers 306 removed from between the channel layers 308 forming nanowires.

A gate dielectric layer may then be deposited using chemical vapor deposition 224 around the nanowires. The material forming the gate dielectric may be a high-k dielectric material having a dielectric constant of greater than 3.9, hafnium oxide, hafnium oxy-nitride, hafnium silicide, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, and combinations thereof. The gate dielectric may exhibit a thickness in the range of 1 Å to 50 Å.

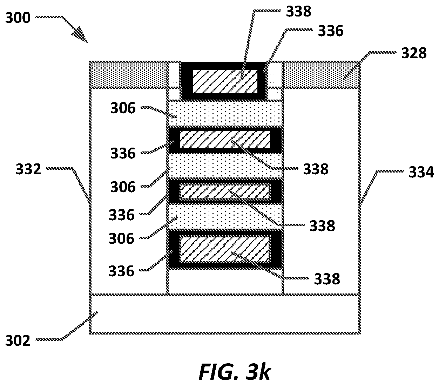

Further, a gate electrode material may be deposited over the gate dielectric layer 226 filling in the regions between the nanowires. Examples of gate materials include, for example, metal nitrides, metal carbide, metal silicides, metal aluminides, hafnium, zirconium, titanium, tantalum, aluminum, ruthenium, palladium, cobalt, nickel, tungsten and conductive metal oxides. FIG. 3k illustrates the semiconductor device 300 including the gate dielectric 336 deposited over the surfaces of the nanowires 308 and remaining sacrificial layer 306 on either side of the channel region of the nanowires 308. FIG. 3k also illustrates the deposited gate electrode 338 filling the spaces between and around the channel region of the nanowires 308.

In embodiments, the present disclosure is also directed to semiconductor devices formed by the interhalogen or halogen-noble element vapor etching processes described above. For example, the method may be employed in forming planar transistors, non-planar transistors, contacts for both planar and non-planar transistors, as well as other components, or line interconnect trenches in planar and non-planar devices. Semiconductor devices include, for example, integrated circuits comprising a variety of components, such as transistors, diodes, power sources, resistors, capacitors, inductors, sensors, receivers, transceivers, antennas, etc., and features for forming such components such as interconnects, gates, plugs, etc. The components associated with an integrated circuit may be mounted on or connected to the integrated circuit. An integrated circuit is analog or digital and may be used in a number of applications, such as microprocessors, optoelectronics, logic blocks, audio amplifiers, etc., depending on the components associated with the integrated circuit. The integrated circuit may then be employed as part of a chipset for executing one or more related functions in a computing device, such as a computer, handheld device or portable device.

An aspect of the present disclosure relates to a method of etching sacrificial material to form a transistor. The method includes supplying a semiconductor substrate in a reaction chamber, wherein the substrate includes a channel material and a sacrificial material disposed on at least a portion of the channel material. The method further includes providing a vapor including an interhalogen compound or halogen-noble element compound in the reaction chamber, etching at least a portion of the sacrificial material with the vapor, and exposing at least a portion of the channel material from under the sacrificial material.

In embodiments of the above, the channel material comprises silicon and the sacrificial material comprises silicon germanium. In addition, in any of the above embodiments, the interhalogen compound is selected from the group consisting of iodine monochloride (ICl), iodine monobromide (IBr), chlorine trifluoride (CIF₃), bromine trifluoride (BrF₃) and iodine tetrachloride (ICl₄). And in particular embodiments, the interhalogen compound is bromine trifluoride. Further, in any of the above embodiments, the halogen-noble element compound is selected from the group consisting of xenon difluoride (XeF₂), xenon tetrafluoride (XeF₄), xenon hexafluoride (XeF₆), or xenon dibromide (XeBr₂).

In any of the above embodiments, the semiconductor substrate is heated at a temperature in the range of -100 °C to 600 °C, and preferably the semiconductor substrate is heated at a temperature in the range of 20 °C to 30 °C. Further in any of the above embodiments, the vapor is supplied to the reaction chamber at a flow rate in the range of 1 sccm to 1000 sccm, and preferably the vapor is supplied to the reaction chamber at a flow rate in the range of 10 sccm to 200 sccm. In addition, in any of the above embodiments, the reaction chamber is maintained at a pressure in the range of 1 mTorr to 100 mTorr during etching. Furthermore, in any of the above embodiments, etching the sacrificial layer occurs for a time period in the range of 1 second to 600 seconds.

In any of the embodiments above, the method further comprises supplying a carrier gas selected from one or more of the following: Ar, He or N₂. In addition, in particular embodiments, the carrier gas is supplied to the reaction chamber in the range of 1 sccm to 1,000 sccm. Alternatively, or in addition, to the above the carrier gas is supplied in a ratio of carrier gas to etchant gas in the range of 100:1 to 1:100, including all values and ranges therein.

In any of the above embodiments, the semiconductor substrate has a substrate surface, the sacrificial layer is disposed on the semiconductor substrate surface, the channel layer is disposed on the sacrificial layer, a sacrificial gate electrode is disposed over the sacrificial layer and the channel layer and a gate spacer disposed on both sides of the sacrificial gate electrode over the sacrificial layer and the channel layer, wherein etching the sacrificial layer with the vapor removes the sacrificial layer from between the semiconductor substrate and the channel layer forming a nanowire.

Further, in embodiments of the above a plurality of sacrificial layers and a plurality of channel layers alternatingly arranged in a stack are provided on the semiconductor substrate surface. In addition, in embodiments of the above, a high-k dielectric layer is deposited over the nanowire. Also, in embodiments of the above, a gate electric layer is deposited over the high-k dielectric layer.

In another aspect of the present disclosure, a transistor is provided formed according to the method set forth above. And, in yet a further aspect of the present disclosure a plurality of the transistors is included in an integrated circuit.

In yet another aspect of the present disclosure relates to a method of etching sacrificial material to form a channel supported over the surface of a substrate. The method includes supplying a semiconductor substrate in a reaction chamber, wherein the semiconductor substrate has a substrate surface, a sacrificial layer disposed on the semiconductor substrate surface, a channel layer disposed on the sacrificial layer, a sacrificial gate electrode disposed over the sacrificial layer and the channel layer, a gate spacer disposed on both sides of the sacrificial gate electrode over the sacrificial layer and the channel layer. The method also includes etching the sacrificial gate electrode exposing a portion of the channel layer and the sacrificial layer. The method further comprises providing vapor including an interhalogen compound or halogen-noble element compound in the reaction chamber and etching the sacrificial layer with the vapor and removing the sacrificial layer from between the semiconductor substrate and the channel layer forming a nanowire.

In embodiments, the method further comprises providing a plurality of sacrificial layers and a plurality of channel layers alternatingly arranged in a stack on the semiconductor substrate surface. In embodiments of the above, channel layer comprises silicon and the sacrificial layer comprises silicon germanium. Further, in embodiments of the above, the interhalogen compound is bromine trifluoride.

In any of the above embodiments, the semiconductor substrate is heated at a temperature in the range of -100 °C to 600 °C. Further in any of the above embodiments, the vapor is supplied to the reaction chamber at a flow rate in the range of 1 sccm to 1000 sccm. In addition, in any of the above embodiments, the reaction chamber is maintained at a pressure in the range of 1 mTorr to 100 mTorr during etching. Also, in any of the above embodiments, etching the sacrificial layer occurs for a time period in the range of 1 second to 600 seconds.

In any of the embodiments above, the method further includes supplying a carrier gas selected from one or more of the following: Ar, He or N₂. In addition, in any of the embodiments above, the method includes depositing a high-k dielectric layer over the nanowire. Also in any of the embodiments above, the method further comprises depositing a gate electric layer over the high-k dielectric layer.

In yet another aspect, the present disclosure relates to a method of etching sacrificial material from nanowire gates in a gate all around device. The method includes supplying a semiconductor substrate in a reaction chamber, wherein the semiconductor substrate has a substrate surface, a plurality of silicon-germanium sacrificial layers and silicon channel layers stacked alternatingly on the semiconductor substrate surface. The method also includes heating the substrate at a temperature in the range of 20 °C to 30 °C. The method further includes supplying a bromine triflouride at a flow rate in the range of 10 sccm to 200 sccm to the reaction chamber and maintaining the reaction chamber at a pressure in the range of 1 millitorr to 100 millitorr. In addition, the method includes etching the sacrificial layers with the bromine trifluoride vapor for a period of time in the range of 1 second to 600 seconds and removing the silicon-germanium sacrificial layers forming nanowires from the silicon channel layers.

In yet another embodiment, the present disclosure relates to a transistor formed according any of the methods set forth above. In embodiments, a plurality of the transistors is included in an integrated circuit.

The foregoing description of several methods and embodiments has been presented for purposes of illustration. It is intended that the scope of the invention be defined by the claims appended hereto.

## Claims

1. A method of etching sacrificial material to form a transistor, comprising:
supplying (102) a semiconductor substrate in a reaction chamber, wherein said substrate includes a channel material, a sacrificial material disposed on at least a portion of said channel material, and a sacrificial gate electrode disposed over said sacrificial material and said channel material;
etching (218) said sacrificial gate electrode exposing a portion of said channel material and said sacrificial material;
providing (104) a vapor including an interhalogen compound or halogen-noble element compound in said reaction chamber;
etching (106) at least a portion of said sacrificial material with said vapor; and
exposing (108) at least a portion of said channel material from under said sacrificial material.

2. The method according to claim 1, wherein said channel material comprises silicon and said sacrificial material comprises silicon germanium.

3. The method according to any one of claims 1 and 2, wherein said interhalogen compound is selected from the group consisting of iodine monochloride (ICl), iodine monobromide (IBr), chlorine trifluoride (CIF₃), bromine trifluoride (BrF₃) and iodine tetrachloride (ICl₄).

4. The method according to any one of claims 1 to 3, wherein said interhalogen compound is bromine trifluoride.

5. The method according to any one of claims 1 to 4, wherein said semiconductor substrate is heated at a temperature in the range of -100 °C to 600 °C and preferably in the range of 20 °C to 30 °C.

6. The method according to any one of claims 1 to 5, wherein said vapor is supplied to said reaction chamber at a flow rate in the range of 1 sccm to 1000 sccm, and preferably in the range of 10 sccm to 200 sccm.

7. The method according to any one of claims 1 to 6, wherein said reaction chamber is maintained at a pressure in the range of 1 mTorr to 100 mTorr during etching.

8. The method according to any one of claims 1 to 7, wherein etching said sacrificial layer occurs for a time period in the range of 1 second to 600 seconds.

9. The method according to any one of claims 1 to 8, further comprising supplying a carrier gas selected from one or more of the following: Ar, He or N₂.

10. The method according to any one of claims 1 to 9, wherein said semiconductor substrate has a substrate surface, said sacrificial layer is disposed on said semiconductor substrate surface, said channel layer is disposed on said sacrificial layer and a gate spacer is disposed on both sides of said sacrificial gate electrode over said sacrificial layer and said channel layer, wherein etching said sacrificial layer with said vapor removes said sacrificial layer from between said semiconductor substrate and said channel layer forming a nanowire.

11. The method of claim 10, further comprising a plurality of sacrificial layers and a plurality of channel layers alternatingly arranged in a stack on said semiconductor substrate surface.

12. The method according to any one of claims 10 and 11, further comprising depositing a high-k dielectric layer over said nanowire.

13. The method of claim 12, further comprising depositing a gate electric layer over said high-k dielectric layer.

## Patentansprüche

1. Verfahren zum Ätzen von Opfermaterial zur Herstellung eines Transistors, umfassend:
Platzieren (102) eines Halbleitersubstrats in einer Reaktionskammer, wobei das Substrat ein Kanalmaterial, ein Opfermaterial, das auf wenigstens einem Teil des Kanalmaterials angeordnet ist, und eine Opfer-Gate-Elektrode, die über dem Opfermaterial und dem kanalmaterial angeordnet ist, umfasst;
Ätzen (218) der Opfer-Gate-Elektrode, um einen Teil des Kanalmaterials und des Opfermaterials freizulegen;
Zuführen (104) eines Dampfs, der eine Interhalogenverbindung oder eine Halogen-Edelelement-Verbindung enthält, in die Reaktionskammer;
Ätzen (106) wenigstens eines Teils des Opfermaterials mit dem Dampf; und
Freilegen (108) wenigstens eines Teils des Kanalmaterials von unterhalb des Opfermaterials.

2. Verfahren gemäß Anspruch 1, wobei das Kanalmaterial Silicium umfasst und das Opfermaterial Silicium-Germanium umfasst.

3. Verfahren gemäß einem der Ansprüche 1 und 2, wobei die Interhalogenverbindung ausgewählt ist aus der Gruppe bestehend aus Iodmonochlorid (ICl), Iodmonobromid (IBr), Chlortrifluorid (ClF₃), Bromtrifluorid (BrF₃) und Iodtetrachlorid (ICl₄).

4. Verfahren gemäß einem der Ansprüche 1 bis 3, wobei die Interhalogenverbindung Bromtrifluorid ist.

5. Verfahren gemäß einem der Ansprüche 1 bis 4, wobei das Halbleitersubstrat bei einer Temperatur in dem Bereich von -100 °C bis 600 °C und vorzugsweise in dem Bereich von 20 °C bis 30 °C gewärmt wird.

6. Verfahren gemäß einem der Ansprüche 1 bis 5, wobei der Dampf mit einer Flussrate in dem Bereich von 1 sccm bis 1000 sccm, vorzugsweise in dem Bereich von 10 sccm bis 200 sccm, zu der Reaktionskammer zugeführt wird.

7. Verfahren gemäß einem der Ansprüche 1 bis 6, wobei die Reaktionskammer während des Ätzens bei einem Druck in dem Bereich von 1 mTorr bis 100 mTorr gehalten wird.

8. Verfahren gemäß einem der Ansprüche 1 bis 7, wobei das Ätzen der Opferschicht mit einer Zeitdauer in dem Bereich von 1 Sekunde bis 600 Sekunden erfolgt.

9. Verfahren gemäß einem der Ansprüche 1 bis 8, ferner umfassend Zuführen eines Trägergases ausgewählt aus einem oder mehreren der folgenden: Ar, he und N₂.

10. Verfahren gemäß einem der Ansprüche 1 bis 9, wobei das Halbleitersubstrat eine Substratoberfläche aufweist, die Opferschicht auf der Halbleitersubstratoberfläche angeordnet ist, die Kanalschicht auf der Opferschicht angeordnet ist und ein Gate-Abstandshalter an beiden Seiten der Opfer-Gate-Elektrode über der Opferschicht und der Kanalschicht angeordnet ist, wobei das Ätzen der Opferschicht mit dem Dampf die Opferschicht von zwischen dem Halbleitersubstrat und der Kanalschicht entfernt, um einen Nanodraht zu bilden.

11. Verfahren gemäß Anspruch 10, ferner umfassend eine Vielzahl von Opferschichten und eine Vielzahl von Kanalschichten, die in einem Stapel abwechselnd auf der Halbleitersubstratoberfläche angeordnet sind.

12. Verfahren gemäß einem der Ansprüche 10 und 11, ferner umfassend Aufbringen einer high-k-dielektrischen Schicht über dem Nanodraht.

13. Verfahren gemäß Anspruch 12, ferner umfassend Aufbringen einer Gateelektrischen Schicht über der high-k-dielektrischen Schicht.

## Revendications

1. Procédé de gravure d'un matériau sacrificiel pour former un transistor, consistant à :
introduire (102) un substrat semi-conducteur dans une chambre de réaction, ledit substrat comprenant un matériau de canal, un matériau sacrificiel disposé sur au moins une partie dudit matériau de canal, et une électrode de grille sacrificielle disposée sur ledit matériau sacrificiel et ledit matériau de canal ;
graver (218) ladite électrode de grille sacrificielle en faisant apparaître une partie dudit matériau de canal et dudit matériau sacrificiel ;
introduire (104) de la vapeur comprenant un composé interhalogène ou un composé halogène-élément noble dans ladite chambre de réaction ;
graver (106) au moins une partie dudit matériau sacrificiel avec ladite vapeur ; et
faire apparaître (108) au moins une partie dudit matériau de canal depuis le dessous dudit matériau sacrificiel.

2. Procédé selon la revendication 1, dans lequel ledit matériau de canal comprend du silicium et ledit matériau sacrificiel comprend du silicium-germanium.

3. Procédé selon l'une quelconque des revendications 1 et 2, dans lequel ledit composé interhalogène est choisi dans le groupe constitué par le monochlorure d'iode (ICl), le monobromure d'iode (IBr), le trifluorure de chlore (ClF₃), le trifluorure de brome (BrF₃) et le tétrachlorure d'iode (ICl₄).

4. Procédé selon l'une quelconque des revendications 1 à 3, dans lequel ledit composé interhalogène est le trifluorure de brome.

5. Procédé selon l'une quelconque des revendications 1 à 4, dans lequel ledit substrat semi-conducteur est chauffé à une température dans la plage de -100 °C à 600 °C et de préférence dans la plage de 20 °C à 30 °C.

6. Procédé selon l'une quelconque des revendications 1 à 5, dans lequel ladite vapeur est introduite dans ladite chambre de réaction à un débit dans la plage de 1 cm cube standard/min à 1 000 cm cube standard/min, et de préférence dans la plage de 10 cm cube standard/min à 200 cm cube standard/min.

7. Procédé selon l'une quelconque des revendications 1 à 6, dans lequel ladite chambre de réaction est maintenue à une pression dans la plage de 1 mtorr à 100 mtorrs pendant la gravure.

8. Procédé selon l'une quelconque des revendications 1 à 7, dans lequel la gravure de ladite couche sacrificielle se produit pendant une durée dans la plage de 1 seconde à 600 secondes.

9. Procédé selon l'une quelconque des revendications 1 à 8, consistant en outre à introduire un gaz porteur choisi parmi un ou plusieurs des éléments suivants : Ar, He ou N₂.

10. Procédé selon l'une quelconque des revendications 1 à 9, dans lequel ledit substrat semi-conducteur possède une surface de substrat, ladite couche sacrificielle est disposée sur ladite surface de substrat semi-conducteur, ladite couche de canal est disposée sur ladite couche sacrificielle et un espaceur de grille est disposé des deux côtés de ladite électrode de grille sacrificielle sur ladite couche sacrificielle et ladite couche de canal, dans lequel la gravure de ladite couche sacrificielle avec ladite vapeur élimine ladite couche sacrificielle située entre ledit substrat semi-conducteur et ladite couche de canal en formant un nanofil.

11. Procédé selon la revendication 10, comprenant en outre une pluralité de couches sacrificielles et une pluralité de couches de canal agencées de façon alternée en pile sur ladite surface de substrat semi-conducteur.

12. Procédé selon l'une quelconque des revendications 10 et 11, consistant en outre à déposer une couche diélectrique à k élevée sur ledit nanofil.

13. Procédé selon la revendication 12, consistant en outre à déposer une couche électrique de grille sur ladite couche diélectrique à k élevée.
